# EUROPÄISCHE PATENTSCHRIFT

(11) **EP 1 520 320 B1**
(45) Veröffentlichungstag und Bekanntmachung des Hinweises auf die Patenterteilung: **26.09.2012**
(21) Anmeldenummer: 03740103.1
(22) Anmeldetag: 24.06.2003
(51) Int. Cl.: H01L 23/66, H01P 1/04, H01P 11/00

(54) **ELEKTRISCHES BAUELEMENT, INSBESONDERE MIKROELEKTRISCHES ODER MIKROELEKTROMECHANISCHES HOCHFREQUENZBAUELEMENT**
ELECTRICAL SYSTEM, ESPECIALLY A MICROELECTRONIC OR MICROELECTROMECHANICAL HIGH FREQUENCY SYSTEM
COMPOSANT ELECTRIQUE, EN PARTICULIER COMPOSANT HAUTE FREQUENCE MICRO-ELECTRONIQUE OU MICRO-ELECTROMECANIQUE

(30) Priorität: 02.07.2002 DE 10229578
(43) Veröffentlichungstag der Anmeldung: 06.04.2005
(73) Patentinhaber: ROBERT BOSCH GMBH, 70442 Stuttgart (DE)
(72) Erfinder: BREITSCHWERDT, Klaus, 70794 Filderstadt (DE); ULM, Markus, 74372 Sersheim (DE); URBAN, Andrea, 70563 Stuttgart (DE); REIMANN, Mathias, 70567 Stuttgart (DE)
(86) Internationale Anmeldenummer: PCT/DE2003/002087
(87) Internationale Veröffentlichungsnummer: WO 2004/006382

(56) Entgegenhaltungen:
- WO-A-99/62135
- WO-A1-96/13062
- US-A- 5 057 798
- ABHARI R ET AL: "Analysis of microvia interconnects" MICROWAVE SYMPOSIUM DIGEST, 1998 IEEE MTT-S INTERNATIONAL BALTIMORE, MD, USA 7-12 JUNE 1998, NEW YORK, NY, USA,IEEE, US, 7. Juni 1998 (1998-06-07), Seiten 1925-1928, XP010290176 ISBN: 0-7803-4471-5
- GOVERDHANAM K ET AL: "NOVEL THREE-DIMENSIONAL VERTICAL INTERCONNECT TECHNOLOGY FOR MICROWAVE AND RF APPLICATIONS" 1999 IEEE MTT-S INTERNATIONAL MICROWAVE SYMPOSIUM DIGEST. (IMS). ANAHEIM, CA, JUNE 13 - 19, 1999, IEEE MTT-S INTERNATIONAL MICROWAVE SYMPOSIUM, NEW YORK, NY: IEEE, US, Bd. 2, 13. Juni 1999 (1999-06-13), Seiten 641-644, XP000876331 ISBN: 0-7803-5136-3
- PATENT ABSTRACTS OF JAPAN vol. 2002, no. 10, 10. Oktober 2002 (2002-10-10) -& JP 2002 185201 A (KYOCERA CORP), 28. Juni 2002 (2002-06-28)
- TURNER G W ET AL: "SELECTIVE PLASMA ETCHING OF SI FROM GAAS-ON-SI WAFERS FOR MICROWAVEVIA-HOLE FORMATION" ELECTRONICS LETTERS, IEE STEVENAGE, GB, Bd. 26, Nr. 13, 21. Juni 1990 (1990-06-21), Seiten 854-855, XP000107967 ISSN: 0013-5194

## Beschreibung

Die vorliegende Erfindung betrifft ein elektrisches Bauelement, insbesondere ein mikroelektronisches oder mikroelektromechanisches Hochfrequenzbauelement, gemäß dem Oberbegriff des Anspruchs 1, wie aus der US 5,057, 798 bekannt.

Die WO 96/13062 offenbart eine Vorrichtung und ein Verfahren zum Herstellen einer gestapelten Waferanordnung mit Durchgangslöchern welche mit einem elektrisch leitenden Material ausgekleidet sind.

### Stand der Technik

Aus DE 100 37 385 Al ist ein in Mikromechanik gefertigter Hochfrequenz-Kurzschlussschalter bekannt, der eine dünne Metallbrücke aufweist, die zwischen zwei Masseleitun- gen eines koplanaren Wellenleiters gespannt ist. Dieser Hochfrequenzkurzschlussschalter ist beispielsweise für ACC-Anwendungen ("Adaptive Cruise Control") oder SRR- Anwendungen ("Short Range Radar") in Kraftfahrzeugen verwendbar und wird bei Be- triebsfrequenzen von typischerweise von 24 Gigahertz oder 77 Gigahertz betrieben.

Daneben sind vielfältige andere Mikrostrukturbauelement bzw. mikrosystemtechnische Baukomponenten beispielsweise für Anwendungen im Bereich der Hochfrequenztechnik auf Basis von Silizium bekannt. Diese werden auch als MEMS-Bauelemente (microe- lectromechanical structures/system) oder HF-MEMS-Bauelemente (high frequency mic- roelectromechanical structures/system) bezeichnet.

In der Regel ist es bei Mikrostrukturbauelementen und insbesondere mikrostrukturierten Hochfrequenzbauelementen erforderlich, diese vor Umwelteinflüssen wie Feuchte, Luft, Schmutzpartikeln oder sonstigen äusseren Medien oder Gasen zu schützen. Dazu wird vielfach eine Verkappung eingesetzt. Um dabei die Funktion des durch die Verkappung eingeschlossenen Mikrostrukturbauelementes nicht oder nicht zu stark zu beeinträchtigen, ist es erforderlich, eine Leiterstruktur in die Verkappung hineinzuführen. Dabei stellt sich zunächst das Problem der Sicherstellung der nötigen Gasdichtigkeit bzw. Feuchtigkeitsdichtigkeit. Weiter muss bei der Durchführung der Leiterstruktur vom Aussenraum der Verkappung in deren Innenraum insbesondere im Fall eines Hochfrequenzbauelementes sichergestellt bleiben, dass die Leiterstruktur für hochfrequente elektromagnetische Wellen transparent bzw. durchgängig ist, d. h. es darf nicht zu einer nennenswerten Dämpfung oder Störung der Ausbreitung der elektromagnetischen Wellen auf der Leiterstruktur kommen.

In US 6,207,903 B1 wird ein mikrostrukturiertes Siliziumsubstrat in Form einer Membran mit einer hohen elektrischen Leitfähigkeit beschrieben, das Durchführungen zwischen koplanaren Wellenleitern aufweist, die auf unterschiedlichen Seiten des Siliziumsubstrates geführt sind. Diese Durchführungen sind in Form von Kreiskegelstümpfen ausgeführt und dabei von unterschiedlichen Seiten des Substrates in dieses eingeätzt und mit einem Metall gefüllt worden, so dass sich eine Hochfrequenzdurchführung zwischen den auf Oberseite und Unterseite geführten koplanaren Wellenleitern ergibt. Daneben ist dort beschrieben, dass auch pyramidenförmige Durchführungen bekannt sind, die das Substrat durchqueren. Bei dem in US 6,207,903 B1 eingesetzten Ätzverfahren zur Erzeugung der Durchführungen handelt es sich um ein nasschemisches Ätzverfahren, das die Anisotropie der Ätzgeschwindigkeit in Silizium-Einkristallen entlang verschiedener Kristallrichtungen benutzt, so dass sich als Seitenwände der pyramidenförmigen Durchführungen stets kristalline (111)-Ebenen ausbilden. Die Seitenwände sind damit nicht vertikal, sondern bilden stets einen Winkel von 54,75° mit der Substratebene. Dieses Verfahren wird in US 5,913,134 im Zusammenhang mit dem Aufbau von Hochfrequenzbauelementen mit koplanaren Wellenleitern im Detail weiter erläutert.

Die US 6,365,513 B1 offenbart ein elektrisches Bauelement, insbesondere ein mikroelektronisches oder mikroelektromechanisches Bauelement mit einem Grundkörper, der mit mindestens einer Durchführung versehen ist, die eine auf oder in einer Umgebung einer Oberseite des Grundkörpers verlaufende erste Leitstruktur mit einer auf oder in einer Umgebung einer Unterseite des Grundkörpers verlaufenden zweiten Leitstruktur zumindest für hochfrequente elektromagnetische Wellen durchgängig verbindet, wobei die Durchführung in Form eines geraden Prismas oder eines geraden Zylinders ausgebildet ist.

Aus der US 4,348,253 ist ein elektrisches Bauelement, insbesondere ein mikroelektronisches oder mikroelektromechanisches Hochfrequenzbauelement mit einem Grundkörper, der mit mindestens einer Durchführung versehen ist, bekannt. Die Durchführung verbindet eine auf oder in einer Umgebung einer Oberseite des Grundkörpers verlaufende erste Leitstruktur und eine auf oder in einer Umgebung einer Unterseite des Grundkörpers verlaufende zweite Leitstruktur, wobei die Durchführung in Form eines geraden Prismas oder eines geraden Zylinders ausgebildet ist.

US 5,619,752 zeigt einen Wafer mit einem sich von einer Oberfläche zur anderen erstreckenden Via, das mit Hilfe eines Plasmaätzprozesses in den Grundkörper eingeätzt wird.

Aus der US 6,225,651 B1 ist ein Verfahren zur Erzeugung eines elektrischen Bauelements mit einer Durchführung für hochfrequente elektromagnetische Wellen durch einen Grundkörper bekannt, wobei auf einer Oberseite des Grundkörpers zumindest bereichsweise eine elektrisch leitfähige Schicht und auf einer Unterseite des Grundkörpers eine Ätzmaskierung aufgebracht wird, wobei in den Grundkörper mittels der Ätzmaskierung in einem Plasmaätzschritt mindestens eine den Grundkörper durchquerende Verbindung mit mindestens nahezu senkrechten Seitenwänden eingeätzt wird, wobei nach dem Ätzen und einem Entfernen der Ätzmaskierung auf der Unterseite zumindest bereichsweise eine elektrisch leitfähige Schicht aufgebracht wird, und wobei die Verbindung mit einem elektrisch leitenden Material zumindest weitgehend ausgefüllt oder belegt wird.

In J.P. Quine, "Characterization of Via Connections in Slicon Circuit Boards", IEEE Transactions in Microwave Theory and Techniques, Bd. 36, Nr. 1, S. 21-27, Januar 1988 wird die Analyse von leitenden, durch Siliziumdioxid von einem Siliziumwafer isolierten Vias, die zur Verbindung von streifenförmigen Übertragungskanälen dienen, beschrieben.

Schließlich offenbart die WO 02/33782 A1 eine Vorrichtung zur Führung von elektromagnetischen Wellen von einem Wellenleiter zu einem Übertragungskanal. Die Vorrichtung umfasst Kopplungsmittel, die zumindest eine dielektrische Schicht beinhalten, die eine Öffnung aufweist, die als elektrisch leitfähiges Via ausgebildet ist.

Die aus den vorgenannten Publikationen bekannten Durchführungen für mikroelektronische oder mikroelektromechanische Hochfrequenzbauelemente haben den Nachteil, dass sie aufgrund der anisotropen Nassätzung von Silizium mit der (111)-Ebene als Ätzstopp sehr viel Platz benötigen, und dass die auf den dort beschriebenen Silizium-Substraten geführten koplanaren Wellenleiter für hochfrequente elektromagnetische Wellen im Gigahertz-Bereich mit speziellen elektrischen Anpassstrukturen versehen werden müssen, um sie in ein entsprechendes Hochfrequenzbauelement integrieren zu können. Diese Anpassstrukturen führen andererseits zu einer Verschlechterung der Hochfrequenzeigenschaften der elektrischen Bauelemente durch unerwünschte Verluste, eine Verringerung der Bandbreite bzw. das Erfordernis einer speziellen Impedanzanpassung.

Aus der WP 99/62135 A1 ist eine koplanare Wellenleiterstruktur bekannt, bei der auf beiden Seiten eines Grundkörpers Leiterstrukturen angeordnet sind, die mit entsprechenden Durchführungen in Form von W-Cu gefüllten Slots miteinander verbunden sind.

Aufgabe der vorliegenden Erfindung war die Bereitstellung eines elektrischen Bauelementes, insbesondere eines mikroelektronischen oder mikroelektromechanischen Hochfrequenzbauelementes, das einerseits hermetisch verkappbar ist, und bei dem es andererseits nicht zu den vorgenannten Nachteilen der aus dem Stand der Technik bekannten Durchführungen hinsichtlich ihrer Hochfrequenzeigenschaften kommt.

### Vorteile der Erfindung

Das erfindungsgemässe elektrische Bauelement gemäß Anspruch 1 und das erfindungsgemässe Verfahren gemäß Anspruch 14 zu seiner Herstellung hat gegenüber dem Stand der Technik den Vorteil, dass die Durchführungen sehr viel kleiner sind als im Stand der Technik herstellbar sind, und dass auf zusätzliche spezielle Anpassstrukturen zur Integration dieser Durchführungen in eine Schaltung mit Leitstrukturen für hochfrequente elektromagnetische Wellen, insbesondere im Bereich von 1 GHz bis 80 GHz, in der Regel verzichtet werden kann.

Weiter ist vorteilhaft, dass bei der Ausführung des erfindungsgemässen Verfahren für die einzelnen Verfahrensschritte etablierte Techniken eingesetzt werden können, wie sie beispielsweise aus DE 42 41045 Cl bekannt sind. Insbesondere lassen sich mit einem trockenen Plasmaätzen Durchführungen bzw. sogenannte"Vias"mit nahezu senkrechten und glatten Seitenwänden realisieren, die sich durch geringe elektrische Verluste, insbesondere für hochfrequente elektromagnetische Wellen, und eine sehr gute

Integrationsfähigkeit in eine Hochfrequenzschaltungsumgebung auszeichnen. Zudem sind derartige Durchführungen in allen Leitungstypen oder Leitstrukturen aus der Familie der planaren Wellenleiter, d.h. beispielsweise koplanare Wellenleiter, Mikrostreifenleiter oder sogenannte "slot-lines", wie sie bereits in Meinke und Gundlach, "Taschenbuch der Hochfrequenztechnik", Band 2, Verlag Springer, 1992, beschrieben sind, einsetzbar.

Ein weiterer Vorteil der eingesetzten Plasmaätztechnik zur Erzeugung der Durchführung liegt darin, dass die Durchführungen nun mit einem hohen Aspektverhältnis, d.h. einem hohen Verhältnis von Durchmesser zu Höhe von typischerweise 1:10 oder mehr, und gleichzeitig einem in Draufsicht nahezu beliebigen Querschnitt, d.h. beispielsweise rund, quadratisch, rechteckig oder oval, gefertigt werden können.

Vorteilhafte Weiterbildungen der Erfindung ergeben sich aus den in den Unteransprüchen genannten Maßnahmen.

So ist vorteilhaft hinsichtlich der gewünschten Hochfrequenzeigenschaften, wenn die Durchführung mit einem Metall, beispielsweise Gold, als elektrisch leitfähigem Material gefüllt oder belegt ist.

Die Dimensionen der Durchführung liegen bevorzugt in Draufsicht im Bereich einer Fläche von 400 µm² bis 40.000 µm², insbesondere 1.600 µm² bis 10.000 µm² bzw. bei einem Durchmesser von 20 µm bis 200 µm, insbesondere 40 µm bis 100 µm.

Der Grundkörper, d.h. in der Regel ein hochohmiger Siliziumwafer mit einem spezifischen Widerstand von mehr als 100 Ωcm, weist zumindest im Bereich der Durchführung vorteilhaft eine typische Dicke von 100 µm bis 650 µm, beispielsweise 200 µm, auf.

Ein zentrales Problem bei zum Schutz vor äußeren Einflüssen bzw. der Einstrahlung von elektromagnetischen Feldern verpackten oder verkappten Hochfrequenzbauteilen oder mikromechanischen Bauteilen oder Sensorelementen ist schließlich die Durchführung von Leitstrukturen, die mit dem verpackten elektrischen Hochfrequenzbauteil in Verbindung stehen, aus einem von einer Verkappung eingeschlossenen Innenraum nach außen, da diese Durchführungen einerseits hermetisch dicht und andererseits hochfrequenztauglich ausgeführt werden müssen. Ein in einer Weiterbildung der Erfindung verkapptes elektrisches Bauelement vermeidet das Problem der Durchführung der Leitstrukturen durch die Verkappung vorteilhaft über einen Rückseitenkontakt durch den Grundkörper hindurch, so dass um das verkappte Bauteil ein freies Gebiet zur Verfügung steht, das als Bondfläche für die Verkappung verwendet werden kann.

### Zeichnungen

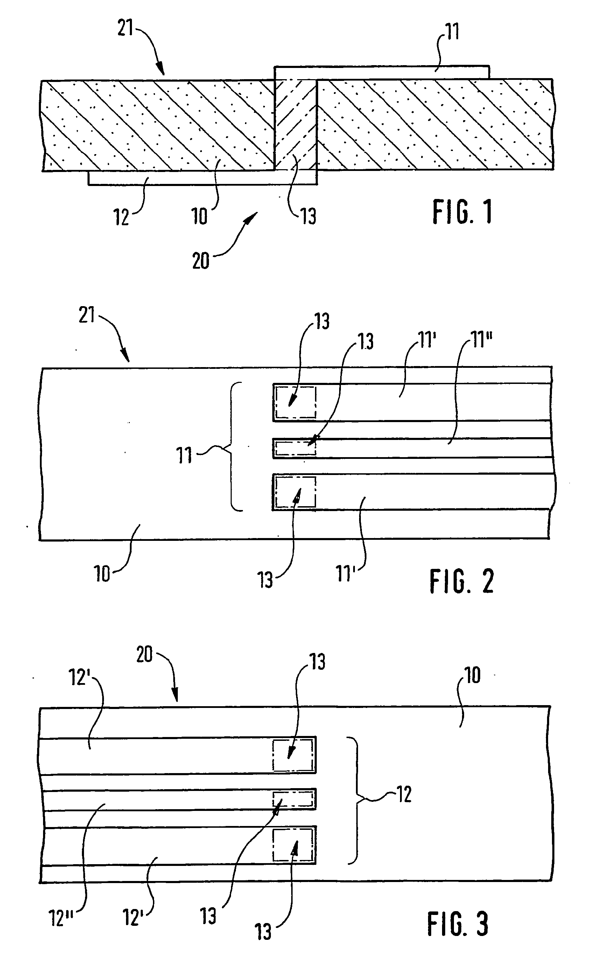

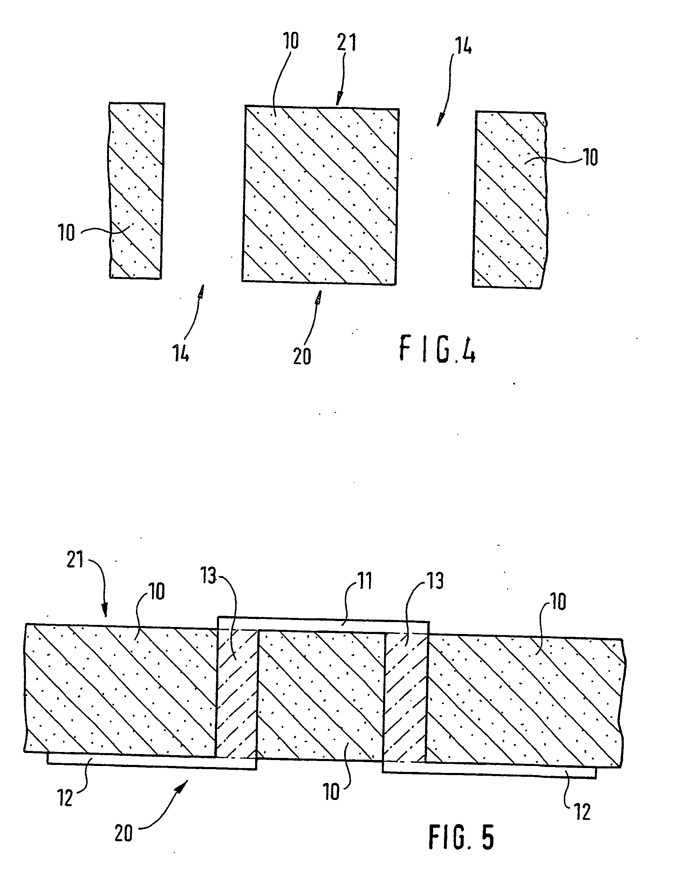

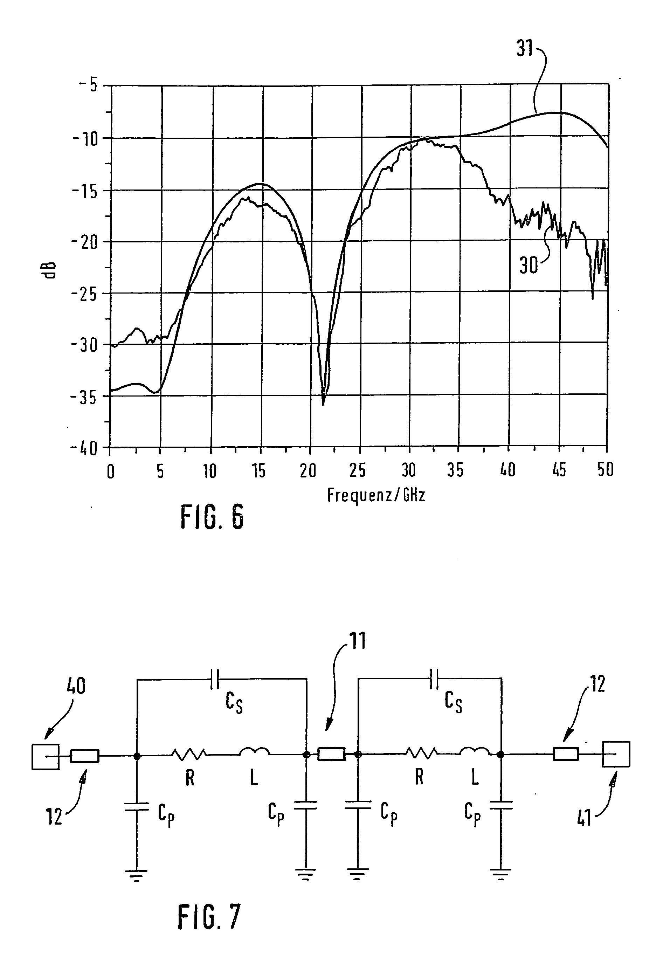

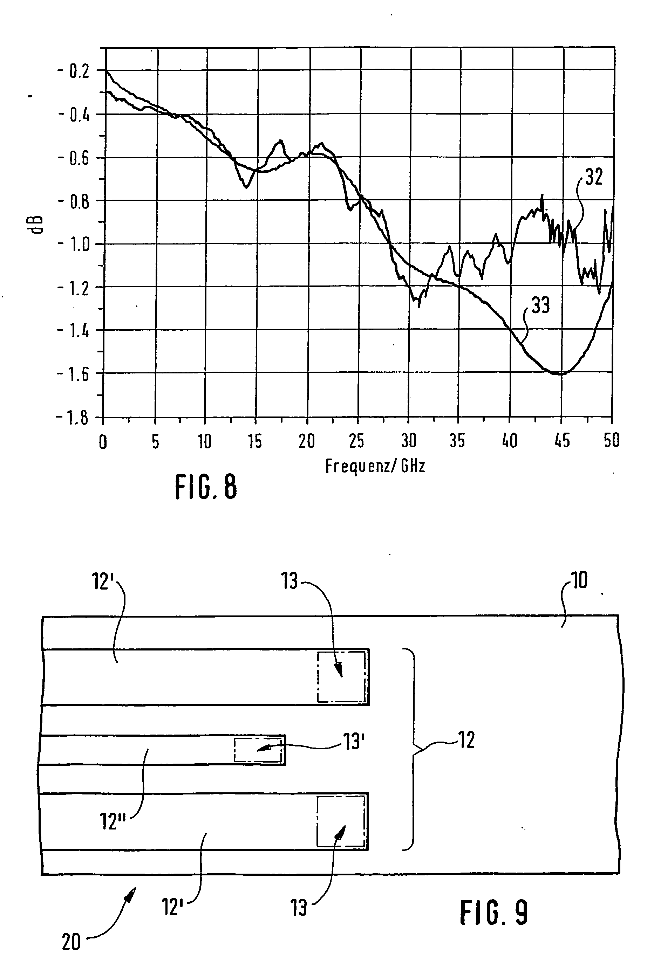

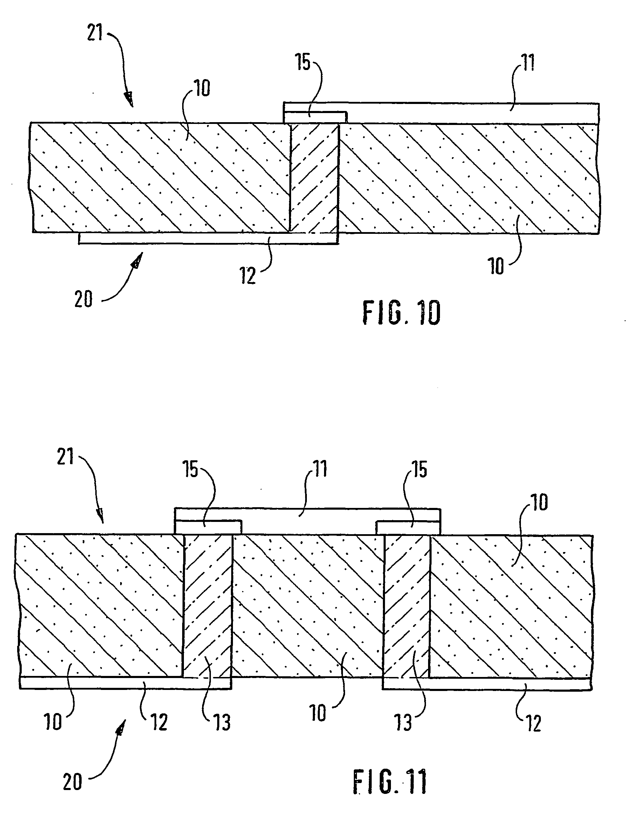

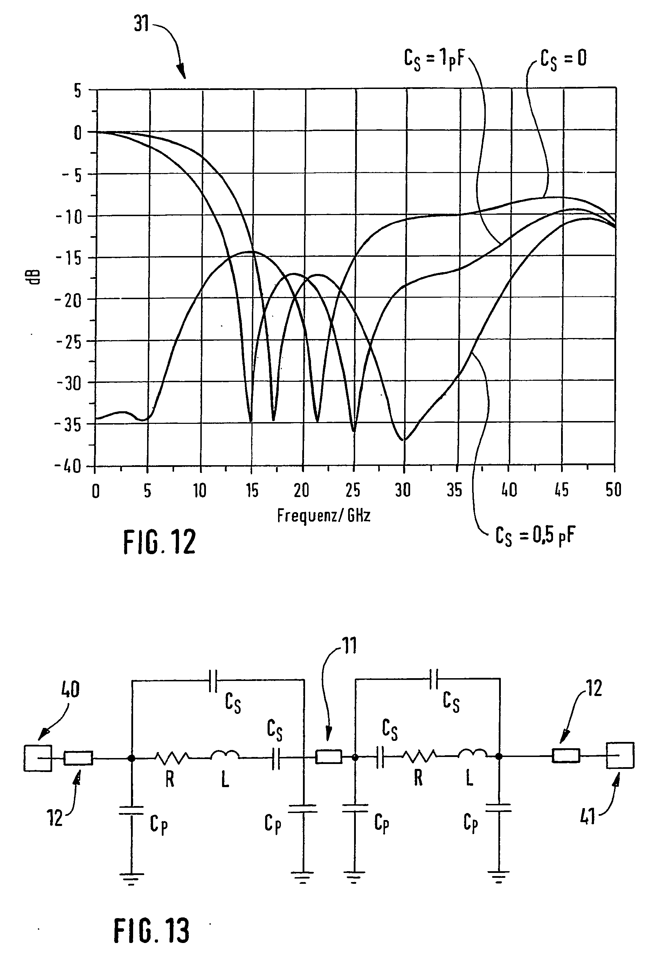

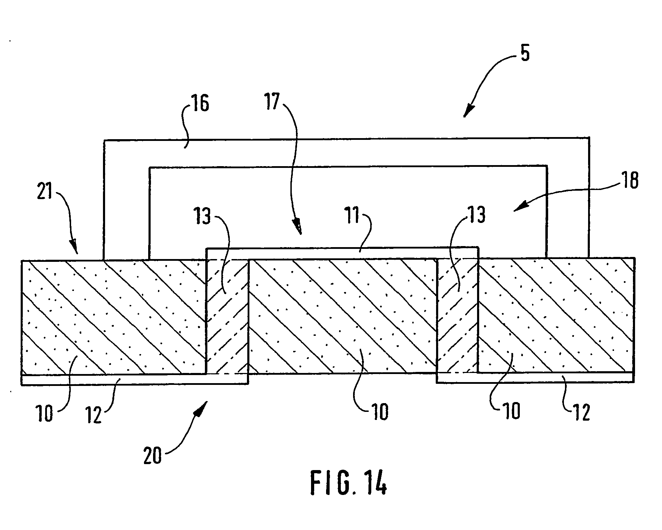

Die Erfindung wird anhand der Zeichnungen und in der nachfolgenden Beschreibung näher erläutert. Es zeigt Figur 1 eine Prinzipskizze eines Schnittes durch einen Ausschnitt eines Bauelementes mit einer Durchführung, Figur 2 eine Draufsicht auf die Oberseite von Figur 1, Figur 3 eine Draufsicht auf die Unterseite von Figur 1, Figur 4 eine Darstellung zweier benachbarter ungefüllter oder unbelegter Durchführungen in einem Grundkörper im Schnitt, Figur 5 eine Prinzipskizze einer Teststruktur mit zwei Durchführungen und ansonsten weitgehend analogem Aufbau gemäß den Figuren 1 bis 3 zur Vermessung der Hochfrequenzeigenschaften dieser Struktur, Figur 6 einen Vergleich einer Messung der Reflexionsdämpfung einer doppelten Viadurchführung gemäss Figur 5 als Funktion der Frequenz und einen Vergleich mit einer Simulation ausgehend von einem Ersatzschaltbild gemäss Figur 7, Figur 7 ein Ersatzschaltbild für den Aufbau gemäss Figur 5, Figur 8 einen Vergleich einer Messung der Transmissionsdämpfung einer doppelten Viadurchführung gemäss Figur 5 im Vergleich mit einer Simulation auf der Grundlage des Ersatzschaltbildes gemäss Figur 7, Figur 9 ein alternatives Beispiel zu den Figuren 1 bis 3 mit einer versetzten Durchführung, Figur 10 ein Ausführungsbeispiel zu den Figuren 1 bis 3 der Erfindung mit einer kapazitiven Kopplung der Leitstrukturen, Figur 11 eine zu Figur 5 weitgehend analoge Teststruktur zur Analyse der Hochfrequenzeigenschaften einer Durchführung mit kapazitiver Kopplung gemäss Figur 10, Figur 12 verschiedene Simulationen der Reflexionsdämpfung einer doppelten Viadurchführung mit kapazitiver Kopplung gemäss Figur 11 als Funktion der Frequenz und der Kapazität, Figur 13 ein Ersatzschaltbild einer doppelten Viadurchführung gemäss Figur 11 und Figur 14 eine Prinzipskizze eines elektrischen Bauelementes im Schnitt mit einer Verkappung, das analog Figur 1, 5 oder 9 gebaut ist.

### Ausführungsbeispiele

Die Figur 1 erläutert ein Beispiel für ein elektrisches Bauelement in Form eines mikroelektronischen Hochfrequenzbauelementes, wobei ein Grundkörper 10 in Form eines hochohmigen Siliziumwafers mit einem spezifischen elektrischen Widerstand von bevorzugt mehr als 1.000 Qcm mit einer Mehrzahl von benachbarten Durchführungen 13 bzw. sogenannten"Vias"versehen ist, die den Grundkörper 10 von dessen Oberseite 21 zu dessen Unterseite 20 durchqueren. Weiter ist auf der Oberseite 21 eine obere Leitstruktur 11 vorgesehen, während sich auf der Unterseite 20 eine untere Leitstruktur 12 befindet. Die Durchführungen 13 sind mit einem Metall, beispielsweise Gold, oder einem anderen, durch eine galvanische Abscheidung abscheidbaren Metall belegt. Schliesslich ist vorgesehen, dass die belegte Durchführung 13 elektrisch leitend mit der oberen Leitstruktur 11 und der unteren Leitstruktur 12 in Verbindung steht, so dass die obere Leitstruktur 11 und die untere Leitstruktur 12 zumindest für hochfrequente elektromagnetische Wellen durchgängig miteinander verbunden sind. Die Durchführung 13 gemäss Figur 1 weist räumlich gesehen die Form eines geraden Prismas oder eines geraden Zylinders auf, das oder der mit dem Metall als elektrisch möglichst gut leitfähiges Material belegt ist.

Die Figur 2 zeigt eine Draufsicht auf Figur 1, so dass erkennbar wird, dass auf der Oberseite 21 insgesamt drei Durchführungen 13 benachbart nebeneinander auf einer gemeinsamen Verbindungslinie angeordnet sind. In Figur 2 sind dabei durch die gepunkteten Linien die in Draufsicht eigentlich nicht sichtbaren Durchführungen 13 angedeutet, die sich unterhalb der oberen Leitstruktur 11 befinden. Die obere Leitstruktur 11 gemäß Figur 2 ist in Form eines koplanaren Wellenleiters ausgeführt, wie er aus US 6,207,903 B1 oder DE 100 37 385 A1 bekannt ist. Insbesondere weist die obere Leitstruktur 11 zwei parallel zueinander verlaufende Masseleitungen 11 auf, die eine Signalleitung 11" einschließen. Weiter werden gemäß Figur 2 die Masseleitungen 11 bzw. die Signalleitung 11" mit Hilfe der diesen jeweils zugeführten Durchführungen 13 von der Oberseite 21 mit der Unterseite 20 des Grundkörpers 10 verbunden.

Die Figur 3 zeigt eine Draufsicht auf die Unterseite 20 gemäß Figur 1 bzw. die gegenüberliegende Seite von Figur 2. Auch hier sind erneut die eigentlich nicht sichtbaren Durchführungen 13 durch gepunktete Linien angedeutet. Auf der Unterseite 20 des Grundkörpers 10 verläuft schließlich auch hier als untere Leitstruktur 12 ein planarer Wellenleiter in Form eines koplanaren Wellenleiters mit zwei zueinander parallelen Masseleitungen 12', die eine Signalleitung 12" einschließen.

Die Figur 4 zeigt einen Schnitt durch einen Grundkörper 10 mit zwei Durchführungen 13 vor deren Ausfüllung oder Belegung mit einem elektrisch leitfähigen Material, beispielsweise einem Metall. Insbesondere ist in Figur 4 erkennbar, wie mit Hilfe eines Plasmatrockenätzverfahrens, beispielsweise gemäß DE 42 41 045 C1, durch anisotrope Plasmaätzung Trenchgräben 14 in das Substrat 10, im erläuterten Beispiel einen Siliziumwafer, eingeätzt worden sind, die senkrecht zu dem zumindest in diesem Bereich ebenen Grundkörper 10 verlaufen, und die diesen durchqueren. Man erkennt deutlich, dass die Trenchgräben 14 nahezu senkrechte und weitgehend glatte Seitenwände aufweisen, wobei der Grundkörper 10 gemäß Figur 4 eine Dicke von ca. 200 µm besitzt, während die Breite der Trenchgräben 14 bei ca. 100 µm liegt.

Die Figur 5 zeigt eine Teststruktur zur Bestimmung der Hochfrequenzeigenschaften eines elektrischen Bauetementes mit einer Durchführung 13 von einer oberen Leitstruktur 11 zu einer unteren Leitstruktur 12 gemäß Figur 1 bzw. Figur 2 und 3. Im Unterschied zu Figur 1 sind hier jedoch zwei Durchführungen 13 vorgesehen, die beispielsweise gemäß Figur 4 beabstandet voneinander ausgebildet und mit einem Metall gefüllt oder belegt sind. Diese beiden Durchführungen 13 verbinden eine auf der Oberseite 21 angeordnete obere Leitstruktur 11 in Form eines koplanaren Wellenleiters gemäss Figur 2 mit zwei unteren Leitstrukturen 12, die ebenfalls als koplanare Wellenleiter jeweils gemäss Figur 3 ausgebildet sind. Die obere Leitstruktur 11 weist gemäss Figur 5 eine Länge l₂ von 0,5 mm bei einer Impedanz von 46 Ω auf, während die unteren Leitstrukturen 12 jeweils eine Länge 11 von 2,35 mm und ebenfalls eine Impedanz von 46 Ω aufweisen. Mit Hilfe der Teststruktur gemäss Figur 5 wird im Bereich eines ersten Messpunktes 40 (Fig.7) eine hochfrequente elektromagnetische Wechselspannung in die Teststruktur eingespeist und im Bereich eines zweiten Messpunktes 41 (Fig.7) das transmittierte Signal aufgenommen.

Die Figur 7 zeigt ein Ersatzschaltbild für die Teststruktur gemäss Figur 5. Dabei ist berücksichtigt, dass die Durchführungen 13 jeweils als Serienschaltungen eines ohm'schen Widerstandes R mit einer Induktivität L, der eine Kapazität C₅ parallel geschaltet ist, dargestellt werden können. Der erhöhte kapazitive Belag innerhalb der Durchführungen 13 wird mit Hilfe der Kapazitäten Cₚ berücksichtigt.

Die Figur 6 zeigt eine Messung der Reflexionsdämpfung 30 elektromagnetischer Wellen im Frequenzbereich von ca. 1 GHz bis ca. 50 GHz an der Teststruktur gemäss Figur 5, sowie einen Vergleich mit einer Simulation der Reflexionsdämpfung 31 in diesem Frequenzbereich, wobei für diese Simulation das Ersatzschaltbild gemäss Figur 7 mit den angegebenen Längen l₁, l₂ und der angegebenen Impedanzen der Leitstrukturen 11,12 herangezogen wurde. Man erkennt, dass Simulation und Messung, abgesehen vom Frequenzbereich grösser 35 GHz, sehr gut übereinstimmen, so dass mit Hilfe des Ersatzschaltbildes gemäss Figur 7 eine Berechnung und damit auch eine gezielte Einstellung der Eigenschaften eines elektrischen Bauelementes; das ähnlich Figur 5 aufgebaut ist, hinsichtlich der Reflexionsdämpfung vorgenommen werden kann.

Die Figur 8 zeigt eine Messung der Transmissionsdämpfung 32 an der Teststruktur gemäss Figur 5, sowie einen Vergleich mit der Simulation der Transmissionsdämpfung 33 der Teststruktur 5, wobei auch hier für die Zwecke der Simulation das Ersatzschaltbild gemäss Figur 7 herangezogen wurde. Auch die Messung der Transmissionsdämpfung 32 befindet sich, abgesehen vom Frequenzbereich grösser 35 GHz, in sehr guter Übereinstimmung mit der Simulation der Transmissionsdämfpung 33.

Die Figur 9 zeigt ein gegenüber dem Beispiel gemäss den Figuren 1 bis 3 geringfügig abgewandeltes Beispiel, wobei die der oberen Signalleitung 11" bzw. unteren Signalleitung 12" zugeordnete Durchführung 13" gegenüber den beiden benachbarten Durchführungen 13 versetzt worden ist, d. h. Figur 9 weist eine versetzte Durchführung 13" auf, die gegenüber der Verbindungslinie der beiden Durchführungen 13 um einen Abstand v von beispielsweise 50 bis 300, insbesondere 150 µm, versetzt ist. Die versetzte Durchführung 13" kann dabei gegenüber der Verbindungslinie der beiden Durchführungen 13, wie in Figur 9 erläutert, zurückgesetzt sein, was bevorzugt ist, sie kann jedoch auch vorversetzt sein. Die Figur 9 zeigt im Übrigen lediglich die Unterseite 20 des Grundkörpers 10, es ist jedoch klar, dass die Oberseite 21 entsprechend aufgebaut ist.

Durch die versetzten Durchführungen 13, 13', sogenannten "staggered Vias", gemäss Figur 9 wird eine Performance-Steigerung hinsichtlich der Transmissionseigenschaften für hochfrequente elektromagnetische Wellen erreicht. Aus Simulation und Messung ergibt sich eine besonders geringe Reflexion und grosse Transmission für elektromagnetische Wellen im GHz-Bereich bei einem Versatz v von 50 µm bis 300, , insbesondere 150 µm.

Die Figur 10 zeigt ein Ausführungsbeispiel der Erfindung, wobei hier im Unterschied zu Figur 1 die obere Leitstruktur 11 von der Durchführung 13 durch ein Dielektrikum 15, insbesondere in Form einer strukturierten dielektrischen Schicht, beispielsweise aus Siliziumdioxid, getrennt ist. Auf diese Weise ist die obere Leitstruktur 11 von der unteren Leitstruktur 12 für Gleichstrom elektrisch isoliert, während für hochfrequente elektromagnetische Wellen eine kapazitive Kopplung durch das Dielektrikum 15 über die Durchführung 13 zwischen oberer Leitstruktur 11 und unterer Leitstruktur 12 gegeben ist, d. h. der Aufbau gemäss Figur 10 wirkt ähnlich einem Kondensator und kann damit vor allem sehr hochfrequente elektromagnetische Wellen im GHz-Bereich weiterhin übertragen.

Das Dielektrikum 15 weist bei einer Grösse der Durchführung 13 von beispielsweise 50, um x 50 u. m bevorzugt eine Dicke von 45 nm bis 1.800 nm, insbesondere 90 nm bis 900 nm auf, was im Rahmen üblicher Technologien gut erreichbare Werte sind, d. h. es bildet mit den Leitstrukturen 11,12 und der Durchführung 13 einen Kondensator mit einer Kapazität von 0, 05 pF bis 4 pF, insbesondere 0,1 pF bis 2 pF. Es ist weiter bevorzugt entsprechend der Fläche der Durchführung 13 in Draufsicht dimensioniert oder geringfütgig grösser ausgeführt und kann zusätzlich auch auf der Unterseite 20 oder alternativ nur auf der Unterseite 20 des Grundkörpers 10 vorgesehen sein. Bevorzugt ist die in Figur 10 gezeigte Variante.

Die Figur 11 zeigt, ausgehend von Figur 10, eine Teststruktur zur Analyse der Übertragungseigenschaften für hochfrequente elektromagnetische Wellen über eine Durchführung mit kapazitiver Kopplung gemäß Figur 10 anhand zweier paralleler Durchführungen 13, die im Bereich eines ersten Messpunktes 40 (Fig. 13) mit hochfrequenten elektromagnetischen Wellen beaufschlagt werden. Die hochfrequenten elektromagnetischen Wellen werden danach im Bereich eines zweiten Messpunktes 41 (Fig. 13) nach transmission durch beide Durchführungen und Übertragung über die Leitstrukturen 12, 11, 12 erfasst. Die Dimensionierung der oberen Leitstruktur 11 bzw. der unteren Leitstruktur 12 sowie der Durchführungen 13 ist in Figur 11, abgesehen von dem Dielektrikum 15, entsprechend der Teststruktur gemäß Figur 5.

Die Figur 13 zeigt ein Ersatzschaltbild für die Teststruktur gemäß Figur 11, das sich von dem Ersatzschaltbild gemäß Figur 7 für die Teststruktur gemäß Figur 5 lediglich durch die zusätzliche, in Reihe mit dem ohm'schen Widerstand R und der Induktivität L geschaltete Kapazität Cₛ unterscheidet, die über das Dielektrikum 15 bereitgestellt wird.

Die Figur 12 zeigt verschiedene Simulationen der Reflexionsdämpfung 31 für elektromagnetische Wellen im Frequenzbereich von ca. 1 GHz bis ca. 50 GHz, die mit Hilfe des Ersatzschaltbildes 13 für die Teststruktur 11 als Funktion der Kapazität Cₛ berechnet worden sind. Dabei ergibt sich für den Fall Cₛ = 0, d.h. den Fall, dass das Dielektrikum 15 nicht vorhanden ist, wieder die Teststruktur gemäß Figur 5 bzw. das Ersatzschaltbild gemäß Figur 7. Insofern deckt sich die Simulation der Reflexionsdämpfung 31 für Cₛ = 0 in Figur 12 mit der entsprechenden Simulation der Reflexionsdämpfung 31 in Figur 6. Als Punktion der Kapazität Cₛ erkennt man in Figur 12 weiter, dass sich die Transmissionseigenschaften der Teststruktur 11 erheblich verändern, so dass es über die Variation der Kapazität Cₛ gezielt und im voraus berechenbar möglich ist, die Transmissions- bzw. Reflexionseigenschaften für hochfrequente elektromagnetische Wellen der Teststruktur 11 an ein gewünschtes Eigenschaftsprofil anzupassen.

Insgesamt führt der Einsatz einer dielektrischen Schicht 15 gemäß Figur 10 bzw. Figur 11 dazu, dass man nun eine gezielte Anpassung der Transmissionseigenschaften der Teststruktur bzw. auch eines elektrischen Bauelementes 5 als Funktion der Frequenz vornehmen kann. So lässt sich durch Veränderung der Kapazität Cₛ von 0,1 pF bis 2 pF die Mittenfrequenz gemäß Figur 12 von ca. 10 GHz bis ca. 50 GHz verschieben.

Die Figur 14 zeigt eine Prinzipskizze eines vollständigen elektrischen Bauelementes 5, insbesondere eines mikroelektronischen oder mikroelektromechanischen Hochfrequenzbauelementes, wobei zwei Durchführungen 13 vorgesehen sind, die jeweils die Unterseite 20 des Grundkörpers 10, der ein Siliziumwafer ist, mit dessen Oberseite 21 verbinden. Auf der Unterseite 20 verlaufen jeweils einer der Durchführungen 13 zugeordnete untere Leitstrukturen 12, die in Form von koplanaren Wellenleitern gemäß Figur 3 ausgebildet sind. Die obere Leitstruktur 11 auf der Oberseite 21 ist ebenfalls als koplanarer Wellenleiter ausgebildet und steht mit einem nicht näher dargestellten elektrischen Bauteil 17 oder Sensorelement, insbesondere einem mikroelektronischen oder mikroelektromechanischen Hochfrequenzbauteil, in Verbindung. Dieses elektrische Bauteil 17 ist beispielsweise eine Hochfrequenzdiode, ein Hochfrequenztransistor, ein in Mikromechanik gefertigter Kurzschlussschalter gemäß DE 100 37 385 A1 oder ein anderes in Mikromechanik gefertigtes Sensorelement.

Schließlich ist gemäß Figur 14 eine Verkappung 16 vorgesehen, die das elektrische Bauteil 17 hermetisch dicht verkappt und somit vor Umwelteinflüssen wie Feuchtigkeit, Korrosion oder Schmutz und unerwünschten Gasen schützt.

Das Material der Verkappung 16 ist bevorzugt ein Material, das einen thermischen Ausdehnungskoeffizienten ähnlich dem des Materials des Grundkörpers 10, d.h. Silizium, aufweist, und das sich auch mikrosystemtechnisch herstellen lässt. Bevorzugt werden als Material für die Verkappung 16 Silizium und Floatglas wie Borosilikat-Floatglas eingesetzt.

Zur Herstellung der Verkappung 16 werden in eine Siliziumscheibe oder Glasscheibe in üblicher Weise geeignet dimensionierte Kavernen eingeätzt, in denen sich später das beispielsweise als mikroelektromechanisches Hochfrequenzbauteil ("HF-MEMS-Struktur") ausgebildete elektrische Bauteil 17 befindet.

Zur Befestigung der Verkappung 16 auf dem Grundkörper 10, insbesondere mit Hilfe eines "Bondrahmens" wird bevorzugt eine Glasfritte eingesetzt. Im Fall des Borosilikat-Floatglases kann man sich auch des anodischen Bondens bedienen. Danach werden die verkappten Bauteile durch Sägen 17 vereinzelt und in eine Schaltungsumgebung integriert. Zudem-können, sofern erforderlich, die verkappten elektrischen Bauteile 17 nach der Metallisierung der Durchführungen 13 integrationsseitig auch noch mit üblichen Anschlusskontakten ("bumps") für einen Löt- oder Klebeprozess versehen werden.

Durch die Verkappung 16 ist somit ein hermetisch dicht abgeschlossener Innenraum 18 entstanden, in dem sich das elektrische Bauteil 17, das über die obere Leitstruktur 11 und die Durchführungen 13 für hochfrequente elektromagnetische Wellen durchgängig mit den unteren Leitstrukturen 12 verbunden und darüber elektrisch ansteuerbar ist, auf dem Grundkörper 10 oder im Bereich der Oberfläche des Grundkörpers 10 befindet.

Den vorstehenden Beispielen und Ausführungsbeispielen ist gemein, dass die Durchführungen 13 von mit Hilfe eines Plasmaätzverfahrens in das Substrat 10 eingeätzten Trenchgräben 14 gebildet werden, die beispielsweise mit einem Metall gefüllt oder belegt wurden. Die Durchführungen 13 sind daher als gefüllte bzw. belegte gerade Prismen, d.h. Körper mit kongruenten Vielecken als Grundflächen, wobei die Kanten senkrecht auf der Grundfläche stehen, oder gefüllte bzw. belegte gerade Zylinder, d.h. Körper, der von einer Zylinderfläche mit geschlossener Leitkurve und zwei parallelen Ebenen, den Grundflächen des Zylinders, begrenzt wird, ausgebildet. Insbesondere sind die Durchführungen 13 gegenüber dem Stand der Technik vergleichsweise klein, und sie weisen ein relativ hohes Aspektverhältnis bei weitgehend beliebigem Querschnitt auf. Im Übrigen sei betont, dass die Dicke des Grundkörpers 10 für die Hochfrequenzeigenschaften der Durchführungen 13 nicht in erster Linie entscheidend ist, sondern vielmehr deren laterale Ausmessungen und ihre Form.

Die erfindungsgemäßen Hochfrequenzdurchführungen (HF-Vias) können bspw. in Kreuzungspunkten angewendet werden. Damit lassen sich verlustarme Hochfrequenzkreuzungen aufbauen.

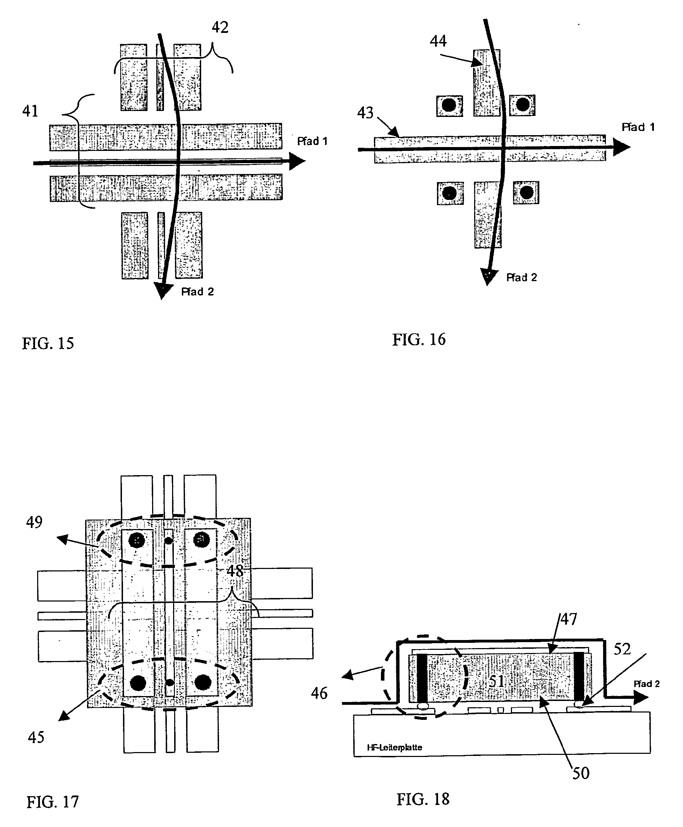

In einer Kreuzung wird der eine Signalpfad durchgeführt, der andere unterbrochen. Die Figur 15 zeigt eine solche Anordnung für koplanare Leiterbahnen (41, 42), die Figur 16 eine solche für Mikrostreifenleitungen (43, 44). Diese Unterbrechung wird nun durch folgende Struktur überdrückt. Ein koplanares HF-Via (45, 46) führt von der Unterseite (50) auf die Oberseite (47) des Substrats (51), bspw. Silicium (vgl. Figuren 17 und 18). Dort läuft eine Koplanarleitung (48) auf die andere Seite der Struktur, wo sich ein weiteres HF-Via (49) anschließt, welches wiederum auf die Unterseite (50) des Substrats (51) führt. Der unten liegende Signalpfad wird also überbrückt, benötigt evtl. jedoch aufgrund des Substrateinflusses eine Impedanzanpassung. Der Chip (Substrat) (51) kann mit Bumps (52) versehen werden und so den elektrischen und mechanischen Kontakt herstellen.

Das Verfahren zur Herstellung einer Durchführung 13 gemäß Figur 1 sieht vor, dass zunächst als Ausgangsmaterial bzw. Grundkörper 10 gereinigtes hochohmiges Silizium mit einem spezifischen Widerstand von mehr als 1.000 Ωm bereitgestellt wird, auf dieses einseitig, z.B. auf der Oberseite 21, eine leitfähige, galvaniktaugliche Metallschicht aufgesputtert und anschließend gegebenenfalls strukturiert wird, danach auf der Unterseite 20 des Grundkörpers 10 ein Fotolack aufgebracht und im Bereich der zu erzeugenden Durchführungen 13 fotolithographisch strukturiert wird, d.h. eine Lackmaske als Ätzmaskierung bildet, nachfolgend in einem Plasmatrockenätzschritt, beispielsweise gemäß DE 42 41 045 C1 das Silizium im Bereich der zu erzeugenden Durchführungen 13 durch den Grundkörper 10 hindurch bis zu der gegenüber liegenden Metallschicht durchgeätzt wird, nach anschließender Entfernung der Lackmaske die zunächst nicht metallisierte Seite des Grundkörpers 10 durch Sputtern ebenfalls zumindest bereichsweise metallisiert wird, danach durch Aufbringen einer Lackmaske auf beiden Seiten des Grundkörpers 10 und anschließender galvanischer Verstärkung die Leitstrukturen 11, 12 in Form von beispielsweise koplanaren Wellenleitern für hochfrequente elektromagnetische Wellen erzeugt und gleichzeitig die erzeugten Durchführungen 13 metallisch verstärkt werden, und abschließend durch einen Ätzschritt für Zwecke der galvanischen Verstärkung erzeugte übliche Galvanikzuleitungen beidseitig wieder entfernt werden, so dass neben den Leitstrukturen 11, 12 die erzeugten, mit einem Metall belegten Durchführungen 13 stehen bleiben.

Eine alternative Variante zu diesem Verfahren sieht vor, dass nach dem Bereitstellen des gereinigten hochohmigen Siliziums als Ausgangsmaterial auf die Oberseite 21 zunächst eine dielektrische Schicht einseitig aufgebracht und gegebenenfalls strukturiert wird, danach die leitfähige, galvaniktaugliche Metallschicht einseitig aufgesputtert und gegebenenfalls strukturiert wird, nachfolgend erneut auf der Unterseite 20 ein Fotolack aufgebracht und im Bereich der zu erzeugenden Durchführungen 13 fotolithographisch strukturiert wird, so dass eine Lackmaske als Ätzmaskierung entsteht, und danach in einem Plasmaätzschritt das Silizium im Bereich der zu erzeugenden Durchführungen 13 bis zu der auf der gegenüber liegenden Seite vorhandenen dielektrischen Schicht durchgeätzt wird, wodurch sich Trenchgräben 14 bilden, die den Grundkörper 10 senkrecht durchqueren. Nach einem Entfernen der Lackmaske als Ätzmaskierung wird dann zunächst die dielektrische Schicht, die bevorzugt eine Oxidschicht ist, zumindest im Bereich der zu erzeugenden Durchführungen 13 wieder entfernt, und die zunächst nicht metallisierte Seite des Grundkörpers 10, beispielsweise durch Sputtern, metallisiert, bevor erneut durch Aufbringen von Fotolackmasken auf beiden Seiten des Grundkörpers 10 und anschlie-βende galvanische Verstärkung die Leitstrukturen 11 bzw. 12 erzeugt und die Durchführung 13 metallisch verstärkt bzw. mit einem Metall belegt wird. Abschließend werden dann in einem Ätzschritt erzeugte Galvanikzuleitungen beidseits des Grundkörpers 10 wieder entfernt, so dass nur die Leitstrukturen 11, 12 und die Durchführung 13 bestehen bleiben.

Ergänzend sei noch betont, dass sich die vorstehend erläuterten Verfahren zur Realisierung aller bekannten Typen von Leitstrukturen und insbesondere planaren Wellenleitern wie koplanaren Wellenleitern, Mikrostreifenleitern und sogenannten "slot-lines" eignen.

Das Verfahren zur Erzeugung eines elektrischen Bauelementes 5 gemäß Figur 10 mit einer kapazitiven Kopplung durch ein Dielektrikum 15 unterscheidet sich von dem vorstehend erläuterten Verfahren lediglich dadurch, dass nach dem Entfernen der Ätzmaskierung nach dem Plasmaätzschritt das Dielektrikum 15, das erneut bevorzugt als Oxidschicht vorliegt, in dem Bereich der Durchführung 13 nicht wieder entfernt wird, und in Gegenwart des Dielektrikums 15 die noch nicht metallisierte Seite des Grundkörpers 10 beispielsweise durch Sputtern metallisiert wird. Das weitere Vorgehen ist dann wie vorstehend bereits beschrieben.

Zusätzlich zum Einsatz einer dielektrischen Schicht 15 zur kapazitiven Kopplung sind erfindungsgemäß im Bereich der oberen Leitstruktur 11 und/oder im Bereich der unteren Leitstruktur 12 im Übrigen auch weitere Serienkapazitäten zur HF-Kompensation eingesetzt, die beispielsweise durch den Leitstrukturen 11, 12 vorgeschaltete kapazitive Leitungsstücke wie beispielsweise Interdigitalkapazitäten realisiert sind.

## Patentansprüche

1. Elektrisches Hochfregnenzbauelement, mit einem Grundkörper (10), der mit mindestens einer Durchfuhrung (13) versehen ist, die eine auf oder in einer Umgebung einer Oberseite (21) des Grundkörpers (10) verlaufende erste Leitstruktur (11) mit einer auf oder in einer Umgebung einer Unterseite (20) des Grundkörpers (10) verlaufenden zweiten Leitstruktur (12) zumindest für hochfrequente elektromagnetische Wellen durchgängig verbindet, wobei die Durchführung (13) in Form eines geraden Prismas oder eines geraden Zylinders ausgebildet ist, wobei die erste und/oder die zweite Leitstruktur (11, 12) als planarer Wellenleiter, wobei die erste oder die zweite Leitstruktur (11, 12) bereichsweise ein kapazitives Bauteile, zur weiteren HF-Kompensation aufweist; **dadurch gekennzeichnet, dass** die obere Leitstruktur (11) oder die untere Leitstruktur (12) von der Durchführung (13) durch ein Dielektrikum (15), getrennt ist.

2. Elektrisches Bauelement nach Anspruch 1, **dadurch gekennzeichnet, dass** die Durchführung (13) mit einem elektrisch leitfahigen Material, insbesondere einem Metall, gefüllt oder belegt ist.

3. Elektrisches Bauelement nach Anspruch 1 oder 2, **dadurch gekennzeichnet, dass** der Grundkörper (10) zumindest in einer Umgebung der Durchführung (13) eben ist, und dass die Durchführung (13) senkrecht zu der von dieser ebenen Umgebung aufgespannten Ebene verläuft und den Grundkörper (10) durchquert.

4. Elektrisches Bauelement nach einem der vorangehenden Ansprüche, **dadurch gekennzeichnet, dass** die Durchführung (13) eine mit Hilfe eines Plasmaätzverfahrens in den Grundkörper (10) eingeätzte und danach mit einem elektrisch leitfähigen Material gefüllte oder belegte Durchführung (13) ist.

5. Elektrisches Bauelement nach einem der vorangehenden Ansprüche, **dadurch gekennzeichnet, dass** die Durchführung (13) in Draufsicht rund, oval, quadratisch oder rechteckig ausgebildet ist.

6. Elektrisches Bauelement nach einem der vorangehenden Ansprüche, **dadurch gekennzeichnet, dass** die Durchführung (13) in Draufsicht eine Fläche von 400 µm² bis 40000 µm², insbesondere von 1600 µm² bis 10000 µm², einnimmt und/oder einen Durchmesser von 20 µm² bis 200 µm², insbesondere 40 µm² bis 100 µm², aufweist.

7. Elektrisches Bauelement nach einem der vorangehenden Ansprüche, **dadurch gekennzeichnet, dass** der Grundkörper (10) im Bereich der Durchfuhrung (13) eine Dicke von 100 µm bis 650 µm aufweist.

8. Elektrisches Bauelement nach einem der vorangehenden Ansprüche, dadurch gekenntzeichnet, dass der Grundkörper (10) eine hochohmige Siliziumscheibe, insbesondere mit einem spezifischen elektrischen Widerstand von mehr als 1000 Ωm ist.

9. Elektrisches Bauelement nach Anspruch 1, **dadurch gekennzeichnet, dass** das Dielektrikum (15) mit den Leitstrukturen (11, 12) und der Durchführung (13) einen Kondensator mit einer Kapazität von 0,05 pF bis 4 pF, insbesondere 0,1 pF bis 2 pF, bildet, und/oder dass das Dielektrikum (15) eine Siliziumoxidschicht mit einer Dicke von 45 nm bis 1800 nm, insbesondere 90 nm bis 900 nm, ist

10. Elektrisches Bauelement nach einem der vorangehenden Ansprüche, **dadurch gekennzeichnet, dass** die obere Leitstruktur (11) als oberer koplanarer Wellenleiter mit einer ersten oberen Masseleitung (11'), einer oberen Signalleitung (11") und einer zweiten oberen Masseleitung (11') ausgebildet ist, die zumindest bereichsweise parallel zueinander verlaufen, dass die untere Leitstruktur (12) als unterer koplanarer Wellenleiter mit einer ersten unteren Masseleitung (12'), einer unteren Signalleitung (12") und einer zweiten unteren Masseleitung (12') ausgebildet ist, die zumindest bereichsweise parallel zueinander verlaufen, dass die erste Masseleitung (11') der oberen Leitstruktur (11) mit der ersten Masseleitung (12') der unteren Leitstruktur (12) über eine erste Durchführung (13), die zweite Masseleitung (11') der oberen Leitstruktur (11) mit der zweiten Masseleitung (12') der unteren Leitstruktur (12) über eine zweite Durchführung (13) und die Signalleitung (11") der oberen Leitstruktur (11) mit der Signalleitung (12") der unteren Leitstruktur (11) über eine dritte Durchführung (13) in Verbindung steht, und dass die dritte Durchführung (13') gegenüber der ersten Durchführung (13) und der zweiten Durchführung (13) versetzt ist.

11. Elektrisches Bauelement nach Anspruch 10, **dadurch gekennzeichnet, dass** der Versatz (v) der dritten Durchführung (13') in Draufsicht auf den Grundkörper (10) 50 µm bis 300 µm insbesondere 150 µm, beträgt.

12. Elektrisches Bauelement nach einem der vorangehenden Ansprüche, **dadurch gekennzeichnet, dass** die Oberseite (21) des Grundkörpers (10) mit einem elektrischen Bauteil (17) oder Sensorelement, insbesondere einem mikroelektronischen oder mikroelektromechanischen Hochfrequenzbauteil wie einer Hochfrequenzdiode oder einem Hochfrequenztransistor, einem in Mikromechanik gefertigten Kurzschlussschalter für hochfrequente elektromagnetische Wellen oder einem in Mikromechanik gefertigen Sensorelement, versehen ist, das über die Durchführung (13), insbesondere über mindestens zwei derartige Durchführungen (13), von der Unterseite (20) des Grundkörpers (10) elektrisch ansteuerbar ist.

13. Elektrisches Bauelement nach Anspruch 12, **dadurch gekennzeichnet, dass** das elektrische Bauteil (17) auf der Oberseite des Grundkörpers (10) mit einer hermetisch dichten Verkappung (16) versehen ist

14. Verfahren zur Erzeugung eines elektrischen Bauelementes (5) mit einer Durchführung (13) für hochfrequente elektromagnetische Wellen durch einen Grundkörper (10) nach einem der vorangehenden Ansprüche, wobei auf einer Oberseite (21) des Grundkörpers (10) zumindest bereichsweise eine elektrisch leitfähige Schicht und auf einer Unterseite (20) des Grundkörpers (10) eine Ätzmaskierung aufgebracht wird, wobei in den Grundkörper (10) mittels der Ätzmaskierung in einem Plasmaätzschritt mindestens ein den Grundkörper (10) durchquerender Trenchgraben (14) mit zumindest nahezu senkrechten Seitenwänden eingeätzt wird, wobei nach dem Ätzen und einem Entfernen der Ätzmaskierung auf der Unterseite (20) zumindest bereichsweise eine elektrisch leitfahige Schicht aufgebracht wird, und wobei der Trenchgraben (14) mit einem elektrisch leitfahigen Material, zumindest weitgehend ausgefüllt oder belegt wird, wobei nach dem Einätzen des Trenchgrabens (14) beidseits des Grundkörpers (10) Photolackmasken aufgebracht und auf der Oberseite (21) und der Unterseite (20) metallische Leitstrukturen (11, 12), zusammen mit dem den Trenchgraben (14) füllenden oder belegenden elektrisch leitfahigen Material galvanisch abgeschieden werden, und wobei vor dem Abscheiden der elektrisch leitfahigen Schicht auf der Oberseite (21) des Grundkörpers (10) dort bereichsweise eine in Draufsicht an die Fläche der zu erzeugenden Durchführung (13) angepasste oder geringfügig größere dielektrische Schicht (15) abgeschieden wird.

15. Verfahren nach Anspruch 14, **dadurch gekennzeichnet, dass** die elektrisch leitfähige Schicht auf der Oberseite (21) und/oder der Unterseite (20) durch Abscheiden oder Aufsputtern eines Metalls, insbesondere eines für eine nachfolgende galvanische Verstärkung geeigneten Metalls, erzeugt und entsprechend einer auf der Oberseite (21) und/oder der Unterseite (20) zu erzeugenden Leitstruktur (11, 12) strukturiert wird.

16. Verfahren nach Anspruch 15, **dadurch gekennzeichnet, dass** als Ätzmaskierung ein Photolack aufgebracht wird, der photolithographisch strukturiert wird.

17. Verwendung des elektrischen Bauelements nach einem der Ansprüche 1 bis 13 zur Bildung von verlustarmen Hochfrequenzkreuzungen.

## Claims

1. Electrical radio-frequency device comprising a base body (10) which is provided with at least one feedthrough (13) which connects a first conductive structure (11) running on or in the vicinity of an upper side (21) of the base body (10) to a second conductive structure (12) running on or in the vicinity of an underside (20) of the base body (10), in a continuous manner at least for radio-frequency electromagnetic waves, wherein the feedthrough (13) is designed in the form of a right prism or a right cylinder, wherein the first and/or the second conductive structure (11, 12) are/is designed as a planar waveguide, wherein the first or the second conductive structure (11, 12) has, in regions, a capacitive component for further RF compensation, **characterized in that** the upper conductive structure (11) or the lower conductive structure (12) is separated from the feedthrough (13) by a dielectric (15).

2. Electrical device according to Claim 1, **characterized in that** the feedthrough (13) is filled or coated with an electrically conductive material, in particular a metal.

3. Electrical device according to Claim 1 or 2, **characterized in that** the base body (10) is planar at least in the vicinity of the feedthrough (13), and **in that** the feedthrough (13) runs perpendicular to the plane spanned by this planar vicinity and passes through the base body (10).

4. Electrical device according to one of the preceding claims, **characterized in that** the feedthrough (13) is a feedthrough (13) etched into the base body (10) by means of a plasma etching process and subsequently filled or coated with an electrically conductive material.

5. Electrical device according to one of the preceding claims, **characterized in that**, when viewed from above, the feedthrough (13) is round, oval, square or rectangular.

6. Electrical device according to one of the preceding claims, **characterized in that**, when viewed from above, the feedthrough (13) occupies an area of from 400 µm² to 40 000 µm², in particular from 1600 µm² to 10 000 µm², and/or has a diameter of from 20 µm to 200 µm, in particular from 40 µm to 100 µm.

7. Electrical device according to one of the preceding claims, **characterized in that** the base body (10) has a thickness of from 100 µm to 650 µm in the region of the feedthrough (13).

8. Electrical device according to one of the preceding claims, **characterized in that** the base body (10) is a highly resistive silicon wafer, in particular with an electrical resistivity of more than 1000 Ωm.

9. Electrical device according to Claim 1, **characterized in that** the dielectric (15) forms, with the conductive structures (11, 12) and the feedthrough (13), a capacitor with a capacitance of from 0.05 pF to 4 pF, in particular from 0.1 pF to 2 pF, and/or **in that** the dielectric (15) is a silicon oxide layer with a thickness of from 45 nm to 1800 nm, in particular from 90 nm to 900 nm.

10. Electrical device according to one of the preceding claims, **characterized in that** the upper conductive structure (11) is designed as upper coplanar waveguide having a first upper ground line (11'), an upper signal line (11") and a second upper ground line (11') which run parallel to one another at least in regions, **in that** the lower conductive structure (12) is designed as lower coplanar waveguide having a first lower ground line (12'), a lower signal line (12") and a second lower ground line (12') which run parallel to one another at least in regions, **in that** the first ground line (11') of the upper conductive structure (11) is connected to the first ground line (12') of the lower conductive structure (12) via a first feedthrough (13), the second ground line (11') of the upper conductive structure (11) is connected to the second ground line (12') of the lower conductive structure (12) via a second feedthrough (13) and the signal line (11") of the upper conductive structure (11) is connected to the signal line (12") of the lower conductive structure (12) via a third feedthrough (13), and **in that** the third feedthrough (13') is offset with respect to the first feedthrough (13) and the second feedthrough (13).

11. Electrical device according to Claim 10, **characterized in that**, when the base body (10) is viewed from above, the offset (v) of the third feedthrough (13') is 50 µm to 300 µm, in particular 150 µm.

12. Electrical device according to one of the preceding claims, **characterized in that** the upper side (21) of the base body (10) is provided with an electrical component (17) or sensor element, in particular with a microelectronic or microelectromechanical radio-frequency component such as a radio-frequency diode or a radio-frequency transistor, with a short-circuiting switch, manufactured using micromechanical technology, for radio-frequency electromagnetic waves or with a sensor element manufactured using micromechanical technology, which component or element is electrically controllable from the underside (20) of the base body (10) via the feedthrough (13), in particular via at least two of such feedthroughs (13).

13. Electrical device according to Claim 12, **characterized in that** the electrical component (17) on the upper side of the base body (10) is provided with a hermetically tight encapsulation (16).

14. Method for producing an electrical device (5) having a feedthrough (13) for radio-frequency electromagnetic waves through a base body (10) according to one of the preceding claims, wherein an electrically conductive layer is applied, at least in regions, to an upper side (21) of the base body (10) and etching masking is applied to an underside (20) of the base body (10), wherein at least one trench (14) passing through the base body (10) and having at least virtually perpendicular side walls is etched into the base body (10) by means of the etching masking in a plasma-etching step, wherein, after the etching and removal of the etching masking, an electrically conductive layer is applied, at least in regions, to the underside (20), and wherein the trench (14) is at least substantially filled or coated with an electrically conductive material, wherein, after the trench (14) has been etched in, photoresist masks are applied to both sides of the base body (10), and metallic conductive structures (11, 12), together with the electrically conductive material filling or coating the trench (14), are deposited electrolytically on the upper side (21) and the underside (20), and wherein, before the deposition of the electrically conductive layer on the upper side (21) of the base body (10), a dielectric layer (15), which when viewed from above is matched to or slightly larger than the area of the feedthrough (13) to be produced, is deposited there in regions.

15. Method according to Claim 14, **characterized in that** the electrically conductive layer on the upper side (21) and/or the underside (20) is produced by the deposition or sputtering-on of a metal, in particular a metal which is suitable for a subsequent electrolytic reinforcement, and is patterned according to a conductive structure (11, 12) to be produced on the upper side (21) and/or on the underside (20).

16. Method according to Claim 15, **characterized in that** a photoresist, which is patterned using photolithography, is applied as etching masking.

17. Use of the electrical device according to one of Claims 1 to 13 for forming low-loss radio-frequency crossovers.

## Revendications

1. Composant électrique pour hautes fréquences présentant un corps de base (10) doté d'au moins un passage (13) qui relie de manière continue au moins pour les ondes électromagnétiques à haute fréquence une première structure conductrice (11) qui s'étend sur le côté supérieur (21) du corps de base (10) ou au voisinage de ce dernier à une deuxième structure conductrice (12) qui s'étend sur le côté inférieur (20) du corps de base (10) ou au voisinage de ce dernier,
le passage (13) étant configuré sous la forme d'un prisme droit ou d'un cylindre droit,
la première et/ou la deuxième structure conductrice (11, 12) étant configurées comme guides d'ondes plans,
la première ou la deuxième structure conductrice (11, 12) présentant sur certaines parties un composant capacitif qui contribue à la compensation des hautes fréquences,
**caractérisé en ce que**
la structure conductrice supérieure (11) ou la structure conductrice inférieure (12) sont séparées du passage (13) par un diélectrique (15).

2. Composant électrique selon la revendication 1, **caractérisé en ce que** le passage (13) est rempli ou occupé par un matériau électriquement conducteur et en particulier un métal.

3. Composant électrique selon les revendications 1 ou 2, **caractérisé en ce que** le corps de base (10) est plan au moins au voisinage du passage (13) et **en ce que** le passage (13) s'étend perpendiculairement au plan sous-tendu par cet environnement plan et traverse le corps de base (10).

4. Composant électrique selon l'une des revendications précédentes, **caractérisé en ce que** le passage (13) est un passage (13) gravé dans le corps de base (10) par une opération de gravure au plasma et est ensuite rempli ou occupé par le matériau électriquement conducteur.

5. Composant électrique selon l'une des revendications précédentes, **caractérisé en ce que** le passage (13) vu en plan a une configuration ronde, ovale, carrée ou rectangulaire.

6. Composant électrique selon l'une des revendications précédentes, **caractérisé en ce que** le passage (13) occupe vu en plan une surface de 400 µm² à 40 000 µm², en particulier de 1 600 µm² à 10 000 µm² et/ou présente un diamètre de 20 µm à 200 µm et en particulier de 40 µm à 100 µm.

7. Composant électrique selon l'une des revendications précédentes, **caractérisé en ce que** le corps de base (10) présente au niveau du passage (13) une épaisseur de 100 µm à 650 µm.

8. Composant électrique selon l'une des revendications précédentes, **caractérisé en ce que** le corps de base (10) est un disque en silicium à haute résistance ohmique, en particulier d'une résistance électrique spécifique supérieure à 1 000 Ωm.

9. Composant électrique selon la revendication 1, **caractérisé en ce que** le diélectrique (15) forme avec les structures conductrices (11, 12) et le passage (13) un condensateur d'une capacité de 0,05 pF à 4 pF et en particulier de 0,1 pF à 2 pF et/ou **en ce que** le diélectrique (15) est une couche d'oxyde de silicium d'une épaisseur de 45 nm à 1 800 nm et en particulier de 90 nm à 900 nm.

10. Composant électrique selon l'une des revendications précédentes, **caractérisé en ce que** la structure conductrice supérieure (11) est configurée comme guide d'ondes supérieur coplanaire avec un premier conducteur supérieur de masse (11'), un conducteur supérieur de signalisation (11'') et un deuxième conducteur supérieur de masse (11'), dont au moins certaines parties s'étendent parallèlement les unes aux autres, **en ce que** la structure conductrice inférieure (12) est configurée comme guide d'ondes coplanaire inférieur doté d'un premier conducteur inférieur de masse (12'), d'un conducteur inférieur de signalisation (12") et d'un deuxième conducteur inférieur de masse (12'), dont au moins certaines parties s'étendent parallèlement les unes aux autres, **en ce que** le premier conducteur de masse (11') de la structure conductrice supérieure (11) est relié au premier conducteur de masse (12') de la structure conductrice inférieure (12) par un premier passage (13), **en ce que** le deuxième conducteur de masse (11') de la structure conductrice supérieure (11) est relié au deuxième conducteur de masse (12') de la structure conductrice inférieure (12) par un deuxième passage (13), **en ce que** le conducteur de signalisation (11'') de la structure conductrice supérieure (11) est relié au conducteur de signalisation (12") de la structure conductrice inférieure (12) par un troisième passage (13) et **en ce que** le troisième passage (13') est décalé par rapport au premier passage (13) et au deuxième passage (13).

11. Composant électrique selon la revendication 10, **caractérisé en ce que** le décalage (v) du troisième passage (13') vu en plan sur le corps de base (10) est de 50 µm à 300 µm et en particulier de 150 µm.

12. Composant électrique selon l'une des revendications précédentes, **caractérisé en ce que** le côté supérieur (21) du corps de base (10) est doté d'un composant électrique (17) d'un élément de détection, en particulier d'un composant microélectronique ou microélectromécanique à haute fréquence, par exemple une diode à haute fréquence ou un transistor à haute fréquence, d'un commutateur de court-circuit pour les ondes électromagnétiques à haute fréquence réalisé par voie micromécanique, ou d'un élément de détection réalisé par la voie micromécanique et qui peut être commandé électriquement par l'intermédiaire du passage (13) et en particulier par l'intermédiaire d'au moins deux de ces passages (13) depuis le côté inférieur (20) du corps de base (10).

13. Composant électrique selon la revendication 12, **caractérisé en ce que** le composant électrique (17) prévu sur le côté supérieur du corps de base (10) est doté d'une encapsulation (16) hermétiquement étanche.

14. Procédé de formation d'un composant électrique (5) doté d'un passage (13) pour des ondes électromagnétiques à haute fréquence qui traverse un corps de base (10) selon l'une des revendications précédentes,
une couche électriquement conductrice étant appliquée sur au moins certaines parties du côté supérieur (21) du corps de base (10) et un masque de gravure étant appliqué sur le côté inférieur (20) du corps de base (10),
au moins une tranchée (14) traversant le corps de base (10) et dont les parois latérales sont au moins approximativement perpendiculaires étant gravée dans le corps de base (10) au moyen du masque de gravure au cours d'une étape de gravure au plasma,
une couche électriquement conductrice étant appliquée au moins sur certaines parties du côté inférieur (20) après la gravure et l'enlèvement du masque de gravure,
la tranchée (14) étant au moins largement remplie ou occupée par un matériau électriquement conducteur,
des masques en photovernis étant appliqués après la gravure de la tranchée (14) sur les deux faces du corps de base (10) et des structures métalliques conductrices (11, 12) étant déposées galvaniquement avec le matériau électriquement conducteur qui remplit ou occupe la tranchée (14) sur le côté supérieur (21) et le côté inférieur (20),
une couche diélectrique (15) adaptée vue en plan à la superficie du passage (13) à former ou légèrement plus grande que ce dernier étant déposée sur certaines parties du côté supérieur (21) du corps de base (10) avant le dépôt de la couche électriquement conductrice.

15. Procédé selon la revendication 14, **caractérisé en ce que** la couche électriquement conductrice est formée sur le côté supérieur (21) et/ou le côté inférieur (20) par dépôt ou pulvérisation d'un métal et en particulier d'un métal qui convient pour permettre un renfort galvanique ultérieur et est structurée en correspondance à une structure conductrice (11, 12) à former sur le côté supérieur (21) et/ou le côté inférieur (20).

16. Procédé selon la revendication 15, **caractérisé en ce qu'**un photovernis structuré par photolithographie est appliqué comme masque de gravure.

17. Utilisation du composant électrique selon l'une des revendications 1 à 13 pour former des croisements à haute fréquence à faible perte.
